(19) Europäisches Patentamt
European Patent Office
Office européen des brevets

(11) **EP 4 170 479 B1**

(12) **FASCICULE DE BREVET EUROPEEN**

(45) Date de publication et mention
de la délivrance du brevet:
**18.02.2026 Bulletin 2026/08**

(21) Numéro de dépôt: **22200590.2**

(22) Date de dépôt: **10.10.2022**

(51) Classification Internationale des Brevets (IPC):
***G06F 7/544*** *(2006.01)*

(52) Classification Coopérative des Brevets (CPC):
**G06F 7/5443**

(54) **CIRCUIT INTÉGRÉ COMPRENANT UN CALCULATEUR MATÉRIEL ET PROCÉDÉ DE CALCUL CORRESPONDANT**

INTEGRIERTE SCHALTUNG MIT HARDWARERECHNER UND ENTSPRECHENDES BERECHNUNGSVERFAHREN

INTEGRATED CIRCUIT COMPRISING A HARDWARE CALCULATOR AND CORRESPONDING CALCULATION METHOD

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **22.10.2021 FR 2111263**

(43) Date de publication de la demande:
**26.04.2023 Bulletin 2023/17**

(73) Titulaire: **STMICROELECTRONICS (GRENOBLE 2) SAS**
**38000 Grenoble (FR)**

(72) Inventeurs:
• **ASSEMAT, Valérie**
**38800 CHAMPAGNIER (FR)**
• **CARNEL, Isabelle**
**38680 PRESLES (FR)**
• **RIBEIRO DE FREITAS, Jeremy**
**38500 COUBLEVIE (FR)**
• **HILKENS, Edwin**
**38500 COUBLEVIE (FR)**

(74) Mandataire: **Casalonga**
**Casalonga & Partners**
**Bayerstraße 71/73**
**80335 München (DE)**

(56) Documents cités:
**US-B1- 6 279 020 US-B1- 8 458 243**

**Description**

Des modes de réalisation et de mise en œuvre concernent les calculateurs matériels, réalisés de façon intégrée, en particulier adaptés pour effectuer des calculs parallèles des composantes de vecteur de sortie d'un produit de convolution.

Typiquement, et en particulier dans des algorithmes de filtre à réponse impulsionnelle finie « FIR » (acronyme des termes anglais usuels « Finite Impulse Response »), un produit de convolution entre un vecteur d'entrée $\{x_i\}_{0 \leq i \leq M-1}$ et un autre vecteur d'entrée $\{b_i\}_{0 \leq i \leq N-1}$ résulte à un vecteur de sortie $\{Y_m\}_{0 \leq m \leq N-1}$ dont chaque composante est définie par la formule

$$Y_m = \sum_{k=0}^{N-1} b_k x_{m-k} \ .$$

Usuellement, les données du vecteur d'entrée $\{x_i\}_{0 \leq i \leq M-1}$ peuvent être appelées « échantillons » (« samples » en anglais) et les données du vecteur d'entrée $\{b_i\}_{0 \leq i \leq N-1}$ peuvent être appelées « taps ».

Des calculateurs matériels peuvent être spécifiquement dédiés aux calculs du type multiplications et accumulations « MAC » des composantes $Y_m$ du vecteur de sortie d'un tel produit de convolution. L'usage de calculateurs matériel permet d'optimiser la charge de travail d'une unité de calculs à usage général, typiquement un processeur d'un système sur puce, et d'optimiser le temps de calcul du vecteur de sortie, appelé temps d'inférence.

Des calculateurs matériels optimisés sont capables, en une instruction, d'effectuer simultanément deux calculs de multiplication-accumulation, ainsi qu'un chargement des deux prochains échantillons $x_i$ et un chargement des deux prochains taps $b_i$ pour les deux prochaines opérations de multiplication-accumulation.

Ainsi, le nombre de multiplications-accumulations pour calculer toutes les composantes du vecteur de sortie est égal au produit du nombre d'échantillons $x_i$ par le nombre de taps $b_i$, par exemple $N \times M$ selon l'exemple de dimensions donné ci-dessus. Et, le nombre de chargements d'échantillons et de taps est aussi égal à $N \times M$.

Les applications des produits de convolution exécutés par des calculateurs matériels tendent à une augmentation de la dimension N, ce qui a un impact quadratique sur le temps d'inférence desdits calculs.

Multiplier le nombre de calculateurs du type MAC en parallèle permet d'optimiser le nombre d'instructions successives, mais nécessite de multiplier le nombre de processus de chargement de données d'entrée à chaque instruction. Les chargements des échantillons et des taps, à partir de mémoires, peuvent devenir le facteur limitant en matière de durée, pour calculer le produit convolution.

Ainsi, il existe un besoin d'optimiser les techniques de multiplication-accumulation afin de réduire la durée nécessaire au calcul complet du produit de convolution.

A cet égard, il est proposé des modes de réalisation et de mise en œuvre permettant d'effectuer à chaque opération, quatre multiplications-accumulations avec seulement deux chargements de données d'entrée.

Selon un aspect, il est proposé à cet égard un circuit intégré comprenant un calculateur matériel adapté pour calculer parallèlement une première composante de sortie $Y_{n-1}$ d'un premier rang $n$ - 1 et une deuxième composante de sortie $Y_n$ d'un deuxième rang n supérieur et consécutif au premier rang, suivant la formule :

$$Y_m = \sum_{k=0}^{N-1} b_k x_{m-k} \ , \text{ en une série d'opérations,}$$

le calculateur matériel comportant une première voie de calcul dédiée à la première composante de sortie $Y_{n-1}$, une deuxième voie de calcul dédiée à la deuxième composante de sortie $Y_n$, dans lequel, à chaque opération, un premier registre est configuré pour contenir une paire de premiers facteurs $\{x_i, x_{i-1}\}$ correspondant aux termes $\{b_k x_{m-k}\}_{[k;k+1]}^{m=n-1}$ de ladite opération dans la première voie, un deuxième registre est configuré pour contenir une paire de deuxièmes facteurs $\{b_j, b_{j+1}\}$ correspondant aux termes $\{b_k x_{m-k}\}_{[k;k+1]}^{m=n-1}$ de ladite opération dans la première voie, et un troisième registre est configuré pour contenir une paire de deuxièmes facteurs ($b_{j+2}$, $b_{j+3}$} correspondant aux termes $\{b_k x_{m-k}\}_{[k+2;k+3]}^{m=n-1}$ de la prochaine opération dans la première voie,

les deux voies de calculs étant configurées pour accéder chacune au premier registre, au deuxième registre et au troisième registre, de manière à utiliser dans chaque opération les premiers facteurs $x_{m-k}$ et les deuxièmes facteurs $b_k$ à la position correspondante de l'indice de sommation $0 \leq k \leq N$ - 1 dans ladite formule de rang $m = n - 1$, $m = n$ respectif à chacune des composantes de sortie $Y_{n-1}$, $Y_n$.

Ainsi, à chaque opération, la première voie de calcul utilise des facteurs prévus pour cette opération contenus dans le premier registre et dans le deuxième, tandis que la deuxième voie de calcul utilise les facteurs correspondant au deuxième rang $m = n$ et à la position correspondante de l'indice de sommation $0 \leq k \leq N$ - 1 commun avec les deuxièmes facteurs de ladite opération en cours dans la première et voie et avec la prochaine opération dans la première voie.

Selon un mode de réalisation, à chaque opération :

- la première voie de calcul est configurée pour calculer et accumuler dans un premier registre de sortie la paire de deux produits $\{b_k x_{m-k}\}_{[k;k+1]}^{m=n-1}$ entre les premiers facteurs $\{x_i, x_{i-1}\}$ contenus dans le premier registre et les deuxièmes facteurs $\{b_j, b_{j+1}\}$ contenus dans le deuxième registre,

- la deuxième voie de calcul est configurée pour calculer et accumuler dans un deuxième registre de sortie la paire de deux produits $\{b_k x_{m-k}\}_{[k;k+1]}^{m=n}$ entre les mêmes premiers facteurs $\{x_i, x_{i-1}\}$ contenus dans le premier registre et les deuxièmes facteurs $\{b_{j+1}, b_{j+2}\}$ correspondant au calcul du deuxième rang $n$, contenus dans le deuxième registre et dans le troisième registre ;
- le calculateur matériel est configuré pour charger dans le premier registre une paire de premiers facteurs $\{x_{i-2}, x_{i-3}\}$ correspondant au calcul de la prochaine opération de la première voie, et pour charger dans le deuxième registre une paire de deuxièmes facteurs $\{b_{j+4}, b_{j+5}\}$ correspondant au calcul de l'opération suivant la prochaine opération de la première voie.

En effet, la configuration des deux voies de calculs accédant aux trois registres d'entrée, permet d'effectuer seulement deux chargements à chaque opération pour permettre les quatre multiplication-accumulation de l'opération suivante.

Selon un autre aspect, il est proposé un circuit intégré comprenant un calculateur matériel adapté pour calculer parallèlement une première composante de sortie $Y_{n-1}$ d'un premier rang $n - 1$ et une deuxième composante de sortie $Y_n$ d'un deuxième rang n supérieur et consécutif au premier rang, suivant la formule :

$$Y_m = \sum_{k=0}^{N-1} b_k x_{m-k}$$ , en une série d'opérations,

le calculateur matériel comportant une première voie de calcul dédiée à la première composante de sortie $Y_{n-1}$, une deuxième voie de calcul dédiée à la deuxième composante de sortie $Y_n$, un premier registre destiné à contenir une paire de premiers facteurs $\{x_i, x_{i-1}\}$, un deuxième registre destiné à contenir une paire de deuxièmes facteurs $\{b_j, b_{j+1}\}$ et un troisième registre destiné à contenir une paire de deuxièmes facteurs $\{b_{j+2}, b_{j+3}\}$, caractérisé en ce qu'à chaque opération, le calculateur matériel est configuré pour :

- avec la première voie, calculer et accumuler dans un premier registre de sortie une paire de deux produits $\{b_k x_{m-k}\}_{[k;k+1]}^{m=n-1}$ entre les premiers facteurs $\{x_i, x_{i-1}\}$ contenus dans le premier registre et les deuxièmes facteurs $\{b_j, b_{j+1}\}$ contenus dans le deuxième registre ;
- avec la deuxième voie, calculer et accumuler dans un deuxième registre de sortie une paire de deux produits $\{b_k x_{m-k}\}_{[k;k+1]}^{m=n}$ entre les mêmes premiers facteurs $\{x_i, x_{i-1}\}$ contenus dans le premier registre et les deuxièmes facteurs $\{b_{j+1}, b_{j+2}\}$ correspondant au calcul du deuxième rang n, contenus dans le deuxième registre et dans le troisième registre ;
- charger dans le premier registre une paire de premiers facteurs $\{x_{i-2}, x_{i-3}\}$ correspondant au calcul de la prochaine opération de la première voie ;
- charger dans le deuxième registre une paire de deuxièmes facteurs $\{b_{j+4}, b_{j+5}\}$ correspondant au calcul de l'opération suivant la prochaine opération de la première voie.

En d'autres termes, les deux voies de calculs sont configurées pour accéder chacune au premier registre, au deuxième registre et au troisième registre, de manière à utiliser dans chaque opération les premiers facteurs $x_{m-k}$ et les deuxièmes facteurs $b_k$ communs pour les rangs $m = n - 1$; $m = n$ de chacune des composantes de sortie $Y_{n-1}$, $Y_n$, et à la position correspondante de l'indice de sommation $0 \leq k \leq N - 1$ dans ladite formule respective au rang de chacune des composantes de sortie $Y_{n-1}$, $Y_n$.

En conséquence de cette configuration des deux voies de calculs de multiplication-accumulation pouvant accéder aux trois registres, le calculateur matériel est capable de calculer quatre termes de multiplication-accumulation pour deux chargements de facteurs dans lesdits registres, à chaque opération.

En effet, le chargement des deuxièmes facteurs $\{b_{j+4}, b_{j+5}\}$ correspondant au calcul de l'opération suivant la prochaine opération de la première voie ; permet, au cours de la prochaine opération :

- d'avoir à disposition les deuxièmes facteurs $\{b_{j+4}, b_{j+5}\}$ (chargées dans le registre appelé « deuxième registre » lors de l'opération précédente) qui seront utilisés dans l'opération suivante par la première voie, mais qui sont utilisés, au moins en partie (au moins un), dans cette opération par la deuxième voie ; et
- d'avoir à disposition les deuxièmes facteurs $\{b_{j+2}, b_{j+3}\}$ (chargées dans le registre appelé « troisième registre » lors de l'opération antérieure à l'opération précédente), utilisés dans cette opération par la première voie et utilisés, au moins en partie (au moins un), dans cette opération par la deuxième voie.

En fait, les qualifications « deuxième » et « troisième » registres sont arbitraires, c'est-à-dire que le circuit intégré comporte matériellement ces deux registres qui peuvent alternativement avoir la fonction définie ci-avant du deuxième registre et la fonction définie ci-avant du troisième registre. Par exemple si, lors d'une opération, (resp.) l'un des registres assure la fonction du « deuxième » registre alors (resp.) l'autre assure la fonction du « troisième » registre, tandis que lors d'une autre opération (opération suivante), ledit (resp.) l'un assurera la fonction du « troisième » registre et (resp.) l'autre assurera la fonction du « deuxième » registre.

Par exemple, à cet égard, le calculateur matériel est configuré, dans la série d'opérations, pour permuter les fonctions du deuxième registre et du troisième registre, à chaque opération successive.

Selon un mode de réalisation, le premier registre, le deuxième registre, le troisième registre ainsi que le premier registre de sortie et le deuxième registre de sortie ont une taille de 2M bits, par exemple 64 bits (M=32), et contiennent chacun une paire de deux données codées sur M bits, par exemple 32bits (M=32).

Selon un mode de réalisation, le calculateur matériel comporte un circuit de sélection configuré pour distribuer les accès au deuxième registre et au troisième registre à la première voie de calcul et à la deuxième voie de calcul, de sorte que la première voie ait accès aux deuxièmes facteurs $\{b_j, b_{j+1}\}$ correspondant à ladite opération contenus dans le deuxième registre, et que la deuxième voie ait accès aux deuxièmes facteurs $\{b_{j+2}, b_{j+3}\}$ correspondant à ladite opération contenus dans le deuxième registre et dans le troisième registre.

En d'autres termes, contrairement aux calculateurs matériels classiques, les registres d'entrées ne sont pas dédiés à une seule voie de calcul, mais sont mutualisés et distribuées entre les différentes voies de calculs par l'intermédiaire du circuit de sélection.

Selon un mode de réalisation, le calculateur matériel est adapté en outre pour calculer parallèlement une troisième composante de sortie $Y_{n+1}$, d'un troisième rang $n + 1$ supérieur et consécutif au deuxième rang n, suivant la même formule, le calculateur matériel comportant une troisième voie de calcul dédiée à la troisième composante de sortie $Y_{n+1}$, et dans lequel, à chaque opération, le calculateur matériel est en outre configuré pour :

- avec la troisième voie, calculer et accumuler dans un troisième registre de sortie une paire de deux produits $\left\{b_k x_{m-k}\right\}_{[k;k+1]}^{m=n+1}$ entre les mêmes premiers facteurs $\{x_i, x_{i-1}\}$ contenus dans le premier registre et les deuxièmes facteurs $\{b_{j+2}, b_{j+3}\}$ correspondant au calcul du troisième rang $n + 1$, contenus dans le troisième registre.

Ainsi, avec une troisième voie de calcul configurée pour elle-aussi accéder au premier registre, au deuxième registre et au troisième registre, on peut utiliser dans chaque opération les premiers facteurs $x_{m-k}$ et les deuxièmes facteurs $b_k$, en outre communs pour le rang $m = n + 1$ et à la position correspondante de l'indice de sommation $0 \leq k \leq N - 1$ dans ladite formule.

En conséquence de cette configuration des trois voies de calculs de multiplication-accumulation pouvant accéder aux trois registres, le calculateur matériel est capable de calculer six termes de multiplication-accumulation pour deux chargements de facteurs dans lesdits registres, à chaque opération.

En effet, le chargement des deuxièmes facteurs $\{b_{j+4}, b_{j+5}\}$ correspondant au calcul de l'opération suivant la prochaine opération de la première voie ; permet en outre, au cours de la prochaine opération :

- d'avoir à disposition les deuxièmes facteurs $\{b_{j+4}, b_{j+5}\}$ (chargées dans le registre appelé « deuxième registre » lors de l'opération précédente) qui seront utilisés dans l'opération suivante par la première voie, mais qui sont utilisés, au moins en partie, dans cette opération par la deuxième voie, et qui sont en outre utilisés dans cette opération par la troisième voie.

Selon un mode de réalisation, le circuit intégré défini ci-avant incorpore un processeur de signaux numériques.

Selon un autre aspect, il est proposé un procédé, mis en œuvre au sein d'un calculateur matériel, de calcul parallèle d'une première composante de sortie $Y_{n-1}$ d'un premier rang $n - 1$ et d'une deuxième composante de sortie $Y_n$ d'un deuxième rang $n$ supérieur et consécutif au premier rang, suivant la formule :

$$Y_m = \sum_{k=0}^{N-1} b_k x_{m-k}$$, en une série d'opérations, dans lequel, à chaque opération :

- le calcul de la première composante $Y_{n-1}$ comprend un calcul et une accumulation de deux produits $\left\{b_k x_{m-k}\right\}_{[k;k+1]}^{m=n-1}$ entre des premiers facteurs $\{x_i, x_{i-1}\}$ contenus dans un premier registre et des deuxièmes facteurs $\{b_j, b_{j+1}\}$ contenus dans un deuxième registre ;
- le calcul la deuxième composante $Y_n$ de un calcul et une accumulation de deux produits $\left\{b_k x_{m-k}\right\}_{[k;k+1]}^{m=n}$ entre les mêmes premiers facteurs $\{x_i, x_{i-1}\}$ contenus dans le premier registre et des deuxièmes facteurs $\{bj_{+1}, bj_{+2}\}$ correspondant au calcul du deuxième rang $n$, contenus dans le deuxième registre et dans un troisième registre ;
- un chargement, dans le premier registre, d'une paire de premiers facteurs $\{x_{i-2}, x_{i-3}\}$ correspondant au calcul de la prochaine opération,
- un chargement, dans le deuxième registre, d'une paire de deuxièmes facteurs $\{b_{j+4}, b_{j+5}\}$ correspondant au calcul de l'opération suivant la prochaine opération de la première voie.

Selon un mode de mise en œuvre, le procédé comprend, dans la série d'opérations, une permutation des fonctions du deuxième registre et du troisième registre, à chaque opération successive.

Selon un mode de mise en œuvre, le premier registre, le deuxième registre, le troisième registre ainsi que le premier registre de sortie et le deuxième registre de sortie ont une taille de 2M bits et contiennent chacun une paire de deux données codées sur M bits.

Selon un mode de mise en œuvre, les accès au deuxième registre et au troisième registre sont distribués de sorte qu'une première voie de calcul dédiée à la première composante de sortie $Y_{n-1}$, ait accès aux deuxièmes facteurs $\{b_j, b_{j+1}\}$ correspondant à ladite opération contenus dans le deuxième registre, et qu'une deuxième voie de calcul dédiée à la deuxième composante de sortie $Y_n$, ait accès aux deuxièmes facteurs $\{b_{j+2}, b_{j+3}\}$ correspondant à ladite opération contenus dans le deuxième registre et dans le troisième registre.

Selon un mode de mise en œuvre, le procédé comprend en outre un calcul parallèle d'une troisième composante de sortie $Y_{n+1}$, d'un troisième rang $n + 1$ supérieur et consécutif au deuxième rang $n$, suivant la même formule, dans lequel, à chaque opération :

- le calcul de la troisième composante $Y_{n+1}$ comprend un calcul et une accumulation de deux produits $\{b_k x_{m-k}\}_{[k;k+1]}^{m=n+1}$ entre les mêmes premiers facteurs $\{x_j, x_{i-1}\}$ contenus dans le premier registre et les deuxièmes facteurs $\{b_{j+2}, b_{j+3}\}$ correspondant au calcul du troisième rang $n + 1$, contenus dans le troisième registre.

D'autres avantages et caractéristiques de l'invention apparaîtront à l'examen de la description détaillée de modes de réalisation et de mise en œuvre, nullement limitatifs, et des dessins annexés, sur lesquels :

[Fig 1] ;
[Fig 2] ;
[Fig 3] ;
[Fig 4] ;
[Fig 5] ;
[Fig 6] ;

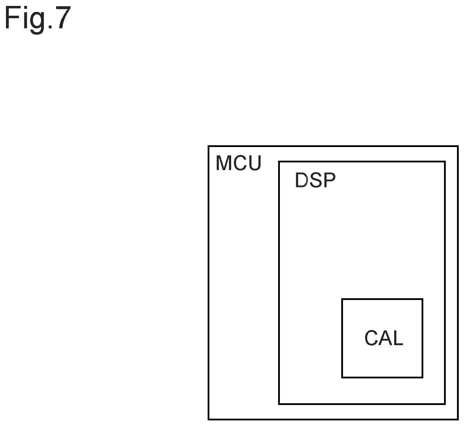

[Fig 7] illustrent des modes de réalisation et de mise en œuvre de l'invention.

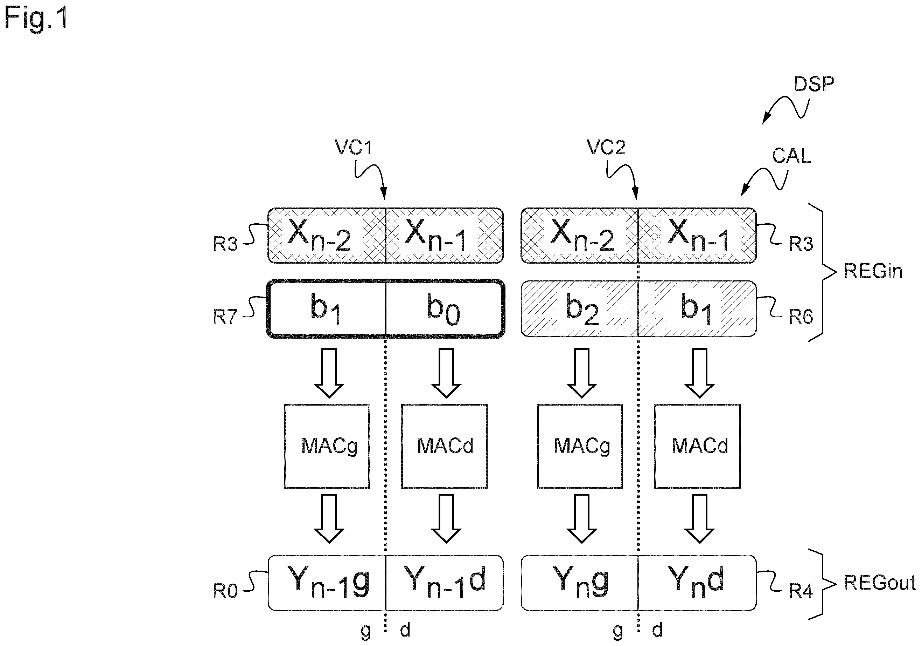

La figure 1 illustre un exemple de calculateur matériel CAL notamment adapté pour calculer des produits de convolutions. Le calculateur matériel peut être réalisé au sein d'un circuit intégré de processeur de signaux numériques DSP.

Les composantes d'un vecteur de sortie d'un produit de convolution peuvent s'exprimer par la formule générale $Y_m = \sum_{k=0}^{N-1} b_k x_{m-k}$, qui est une somme dont chaque terme est le produit de facteurs. Les facteurs sont des données d'entrées de la convolution. Les premiers facteurs $x_{m-k}$ sont par exemple des composantes d'un vecteur d'entrée, autrement appelés « échantillons », les deuxièmes facteurs $b_k$ sont par exemple des coefficients, autrement appelés « taps ».

Le calculateur matériel CAL comporte deux voies de calcul parallèles VC1, VC2, chacune configurée pour effectuer des opérations de multiplications-accumulations MACg, MACd, dans une série d'opérations successives, de sorte que les termes accumulés dans les registres de sortie REGout composent au fur et à mesure une composante de sortie $Y_m$ à l'issue de la série. Chaque opération comprend une multiplication des données $x_{m-k}$, $b_k$ contenues dans des registres d'entrée respectifs REGin, et une accumulation des produits dans un registre de sortie REGout. En outre, dans une opération, un chargement des données d'entrée d'une prochaine opération peut être fait dans les registres d'entrée REGin.

Les voies de calcul VC1, VC2 comportent avantageusement une première optimisation de l'usage des registres d'entrée REGin et de sortie REGout, permettant de limiter le nombre de chargement des données d'entrée dans la série d'opérations. En effet, les registres REGin et REGout ont une taille de 2M bits, par exemple 64bits (M=32) et contiennent chacun deux données distinctes codées sur M bits, par exemple 32 bits. Arbitrairement, dans chaque registre 64bits on distingue ainsi le mot de 32 bits stocké à gauche dans les dessins par la référence « g », et le mot de 32 bits stocké à droite dans les dessins par la référence « d ».

Ainsi, dans chaque voie de calcul VC1, VC2, un seul chargement d'un mot de 2M bits dans un registre d'entrée REGin permet de charger à la fois un premier facteur d'entrée pour une première multiplication-accumulation MACg effectuée dans la partie gauche « g » des registres d'entrée-sortie REGin, REGout, et un autre premier facteur d'entrée pour une deuxième multiplication-accumulation MACd effectuée parallèlement dans la partie droite « d » des registres d'entrée-sortie REGin, REGout. Par exemple, on peut mettre en œuvre les calculs dans les parties de gauche « g » et de droite « d » des registres REGin, REGout, de sortes que les termes de la somme $\sum_{k=0}^{N-1} b_k x_{m-k}$ ayant un indice $k$ paire sont accumulés dans la partie droite « $d$ » du registre de sortie REGout, tandis que les termes ayant un indice $k$ impaire sont accumulés dans la partie gauche « g » du registre de sortie REGout.

Ainsi, indépendamment dans chacune des voies VC1, VC2 et à chaque opération, deux chargements de 64 bits sont suffisants pour réaliser deux multiplications-accumulations MACg, MACd.

En outre, les deux voies de calcul VC1, VC2 peuvent avantageusement partager l'un des deux registres d'entrée REGin, par exemple le registre d'entrée R3 stockant des données d'entrée $x_{n-1}$, $x_{n-2}$, et effectuer les opérations de multiplication-accumulation avec les coefficients $b_k$ ayant les indices $k$ correspondant à ces données d'entrée dans la somme $\sum_{k=0}^{N-1} b_k x_{m-k}$ vis-à-vis du rang $m$ de la composante de sortie $Y_m = \sum_{k=0}^{N-1} b_k x_{m-k}$, respective à chaque voie de calcul VC1, VC2.

Par exemple, la première voie VC1 calcule la composante de sortie $Y_{n-1}$ d'un premier rang $n - 1$ et la deuxième voie calcule la deuxième composante de sortie $Y_n$ d'un deuxième rang $n$. Alors, dans la première voie VC1 au rang $m = n - 1$, on charge les coefficients $b_k$ ayant les indices $k, k + 1$ correspondant aux produits $\{b_k x_{m-k}\}_k^{m=n-1}$ pour les données d'entrée $x_{n-1}$, $x_{n-2}$, (i.e. $(n-1) - k = n - 1; (n-1) - (k+1) = n - 2$ soit $k = 0$, $(k + 1) = 1$), c'est-à-dire les coefficients $b_0$ et $b_1$, dans le deuxième registre d'entrée R7. De manière analogue, dans la deuxième voie VC2 au rang $m = n$, on charge les coefficients $b_k$ ayant les indices $k, k + 1$ correspondant aux produits $\{b_k x_{m-k}\}_k^{m=n}$ pour les données d'entrée $x_{n-1}$, $x_{n-2}$, (i.e. $n - k = n - 1; n - (k+1) = n - 2$ soit $k = 1$, $(k + 1) = 2$), c'est-à-dire les coefficients $b_1$ et $b_2$, dans le troisième registre d'entrée R6.

Cela permet de mutualiser, dans l'ensemble des deux voies VC1, VC2 et à chaque opération, un chargement de 64 bits dans le registre commun R3, de sorte que trois chargements de 64 bits sont suffisants pour réaliser quatre multiplications-accumulations à chaque opération dans l'ensemble des deux voies VC1, VC2.

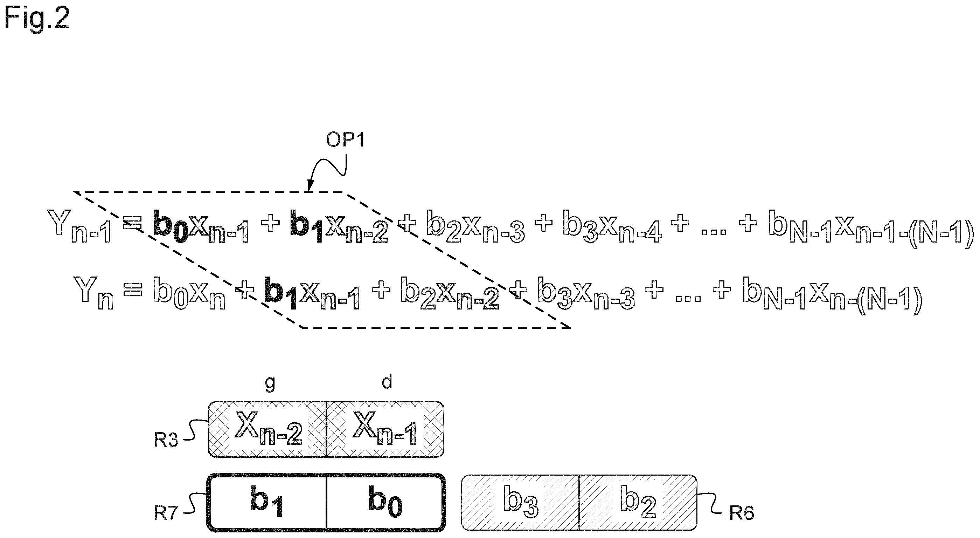

On se réfère désormais aux figures 2 à 5 illustrant un exemple avantageux permettant de réduire à deux le nombre de chargements dans les registres d'entrée REGin (figure 1) pour réaliser les quatre multiplications-accumulations à chaque opération dans l'ensemble des deux voies VC1, VC2.

Le figure 2 illustre le principe de mise en œuvre permettant de mutualiser un chargement supplémentaire dans les registres d'entrée R3, R7, R6, pour la première voie de calcul VC1 et la deuxième voie de calcul VC2 telles que décrites ci-avant en relation avec la figure 1.

D'une part, le premier rang $n - 1$ de la première composante de sortie $Y_{n-1}$ calculée par la première voie VC1, et le deuxième rang n de la deuxième composante de sortie $Y_n$ calculée par la deuxième voie VC2, sont avantageusement consécutifs entre eux. On choisit le cas où le deuxième rang $n$ est supérieur et directement consécutif au premier rang $n - 1$. Cela correspond au cas décrit en relation avec la figure 1.

Dans les figures 2, 4 et 6, la représentation des équations $Y_{n-1}, Y_n$ sont le développement de la formule

$$Y_m = \sum_{k=0}^{N-1} b_k x_{m-k}$$

pour les rangs $n - 1, n$ respectifs, dans lesquelles les motifs de remplissage des lettres correspondent au motif du registre d'entrée R3, R7, R6 qui contient les facteurs respectifs, le motif « vide » ou « blanc » signifiant que ces facteurs ne sont pas chargés dans un registre lors de l'opération OP1.

Lors d'une première opération OP1, effectuée avec les données d'entrée $x_{n-1}, x_{n-2}$, les coefficients $b_0$ et $b_1$ utilisés par la première VC1 sont contenus dans le deuxième registre R7. Pour les mêmes données d'entrée $x_{n-1}, x_{n-2}$, le coefficient $b_1$ utilisé par la deuxième voie VC2 est contenu dans le deuxième registre R7, le coefficient $b_2$ utilisé par la deuxième voie VC2 est contenu dans le troisième registre R6.

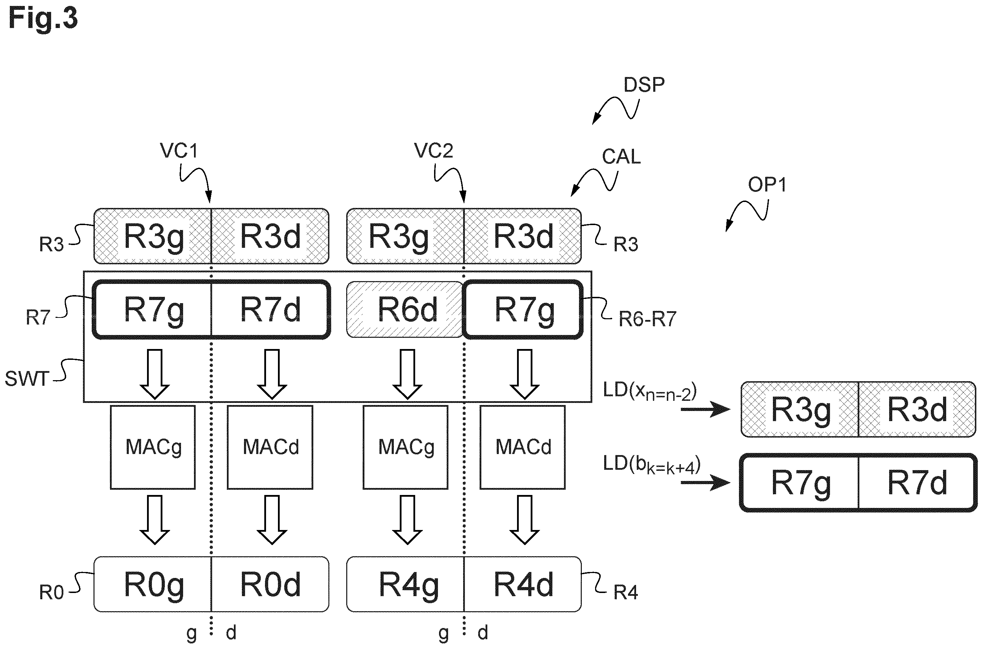

On se réfère à la figure 3, illustrant le calculateur matériel CAL dans le cadre de la mise en œuvre de la première opération OP1.

Dans la première voie VC1, l'opération de multiplication-accumulation est mise en œuvre de la manière décrite en relation avec la figure 1, c'est-à-dire que les deux produits $\{b_k x_{m-k}\}_{[k;k+1]}^{m=n-1}$ entre les premiers facteurs $\{x_{n-1}, x_{n-2}\}$ contenus dans le premier registre R3 et les deuxièmes facteurs $\{b_0, b_1\}$ contenus dans le deuxième registre R7 sont accumulés dans le registre de sortie R0 de la première voie VC1.

En détails, le produit entre le premier facteur $x_{n-1}$ et le deuxième facteur $b_0$ est accumulé dans la partie droite du registre de sortie R0d, à partir des données contenues dans la partie droite du premier registre R3d et dans la partie droite du deuxième registre R7d. On pourra écrire cette opération de multiplication-accumulation « R0d+=R3d*R7d » (« += » signifiant « accumulation », « * » signifiant « multiplication »). De même, le produit entre l'autre premier facteur $x_{n-2}$ et l'autre deuxième facteur $b_1$ est accumulé dans la partie gauche du registre de sortie R0g, tel que « R0g+=R3g*R7g ».

Dans la deuxième voie VC2, l'opération de multiplication-accumulation est mise en œuvre de sorte que les deux produits $\{b_k x_{m-k}\}_{[k;k+1]}^{m=n}$ entre les premiers facteurs $\{x_{n-1}, x_{n-2}\}$ contenus dans le premier registre R3 et les deuxièmes facteurs $\{b_1, b_2\}$ contenus dans le deuxième registre R7 et dans le troisième registre R6 sont accumulés dans le registre de sortie R4 de la deuxième voie VC2.

En détails, dans la deuxième voie VC2, le produit entre le premier facteur $x_{n-1}$ et le deuxième facteur $b_1$ est accumulé dans la partie droite du registre de sortie R4d, à partir des données contenues dans la partie droite du premier registre R3d et dans la partie gauche du deuxième registre R7d, tel que « R4d+=R3d*R7g ». Et, le produit entre l'autre premier facteur $x_{n-2}$ et l'autre deuxième facteur $b_2$ est accumulé dans la partie gauche du registre de sortie R4g, à partir des données contenues dans la partie gauche du premier registre R3g et dans la partie droite du troisième registre R6d, tel que « R4g+=R3g*R6d ».

A cet égard, le calculateur matériel CAL peut comporter un circuit de sélection SWT configuré pour distribuer les accès au deuxième registre R7 et au troisième registre R6, à la première voie de calcul VC1 et à la deuxième voie de calcul VC2. Le circuit de sélection SWT est configuré pour distribuer distinctement les parties gauches et droites desdits registres R7, R6.

Dans la première opération OP1, la distribution est faite de sorte que la partie gauche MACg de la première voie VC1 reçoit en entrée la partie gauche du premier registre R3g et la partie gauche du deuxième registre R7g ; la partie droite MACd de la première voie VC1 reçoit en entrée la partie droite du premier registre R3d et la partie droite du deuxième registre R7d. Tandis que la partie gauche MACg de la deuxième voie VC2 reçoit en entrée la partie gauche du premier registre R3g et la partie droite du troisième registre R6d ; et la partie droite MACd de la deuxième voie VC2 reçoit en entrée la partie droite du premier registre R3d et la partie gauche du deuxième registre R7g.

Ainsi la première voie VC1 a accès aux deuxièmes facteurs $(b_j, b_{j+1})$ de l'opération correspondante contenus dans le deuxième registre R7, et la deuxième voie VC2 a accès aux deuxièmes facteurs $\{b_{j+2}, b_{j+3}\}$ de l'opération correspondante contenus dans le deuxième registre R7g et dans le troisième registre R6d.

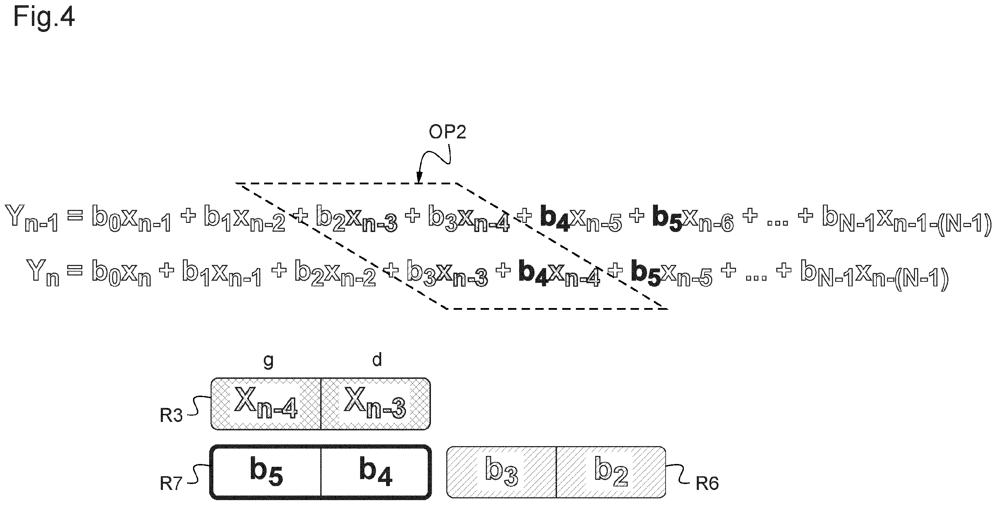

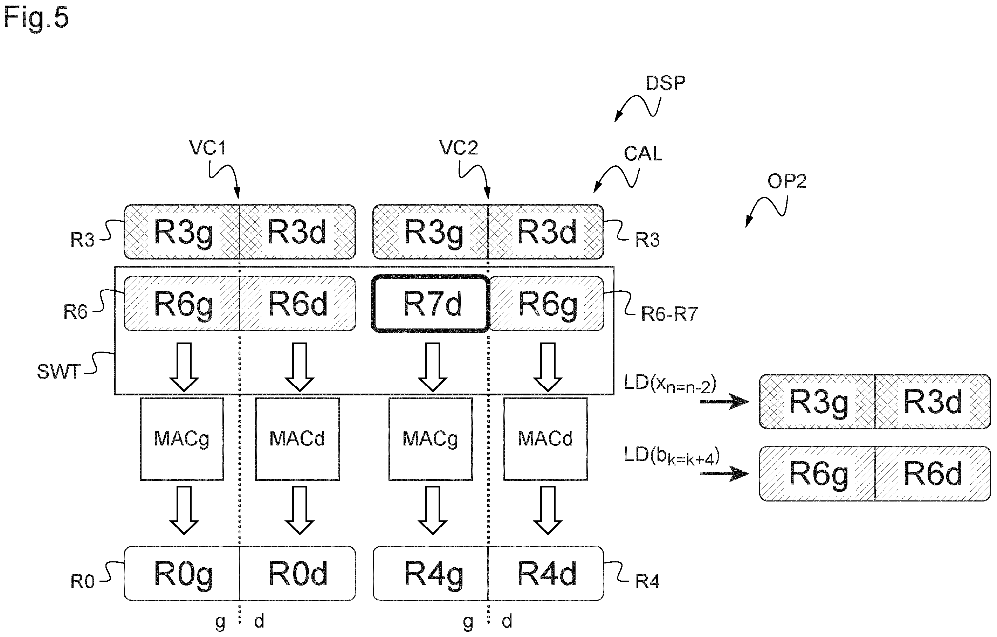

Simultanément aux calculs de multiplication-accumulation parallèles dans les deux voies de calculs VC1, VC2, le calculateur matériel CAL est configuré pour effectuer, dans le premier registre R3, un chargement *LD* $(x_{n=n-2})$ de la paire de premiers facteurs $\{x_{n-3}, x_{n-4}\}$ correspondant au calcul de la prochaine opération OP2 (figures 4 et 5) de la première voie VC1 et de la deuxième voie VC2 ; ainsi que, dans le deuxième registre R7, un seul autre chargement $LD(b_{k=k+4})$ de la paire de deuxièmes facteurs $\{b_4, b_5\}$ correspondant au calcul de l'opération suivant la prochaine opération OP2 de la première voie VC1.

En conséquence, lors de la prochaine opération OP2, le deuxième registre R7 et le troisième registre R6 contiendront des deuxièmes facteurs $\{b_2, b_3\}$ $\{b_4, b_5\}$ d'une manière comparable à leur contenu au commencement de la première opération OP1.

On se réfère à cet égard à la figure 4.

La figure 4 illustre le principe de mise en œuvre des calculs dans la première voie VC1 et dans la deuxième voie VC2, lors de la prochaine opération après la première opération OP1, c'est-à-dire lors de la deuxième opération OP2.

On rappelle qu'à l'issue des chargements effectués lors de la première opération OP1, le premier registre d'entrée R3 contient les données d'entrée $x_{n-3}$, $x_{n-4}$, le deuxième registre d'entrée R7 contient les coefficients $b_4$ et $b_5$ correspondant aux produits $\{b_k x_{m-k}\}_k^{m=n-1}$ pour les données d'entrée $x_{n-5}$, $x_{n-6}$ de l'opération suivant la deuxième opération OP2, dans la première voie VC1. Le troisième registre R6 n'a pas été chargé avec de nouvelles données, et contient donc les coefficients $b_2$ et $b_3$, correspondant aux produits $\{b_k x_{m-k}\}_k^{m=n-1}$ pour les données d'entrée $x_{n-3}$, $x_{n-4}$ de l'opération suivant la première opération OP1, dans la première voie VC1, c'est-à-dire la deuxième opération OP2 en cours dans la première voie VC1.

Lors de la deuxième opération OP2, avec les données d'entrée $x_{n-3}$, $x_{n-4}$, les coefficients $b_2$ et $b_3$ pour la première VC1 sont contenus dans le troisième registre R6. Pour les mêmes données d'entrée $x_{n-3}$, $x_{n-4}$, le coefficient $b_3$ utilisé par la deuxième voie VC2 est contenu dans le troisième registre R6, et le coefficient $b_4$ utilisé par la deuxième voie VC2 est contenu dans le deuxième registre R7.

On se réfère à la figure 5, illustrant le calculateur matériel CAL dans le cadre de la mise en œuvre de la deuxième opération OP2, suivant (après) la première opération OP1.

Dans la première voie VC1, l'opération de multiplication-accumulation est mise en œuvre de sorte que les deux produits $\{b_k x_{m-k}\}_{[k;k+1]}^{m=n-1}$ entre les premiers facteurs $\{x_{n-3}, x_{n-4}\}$ contenus dans le premier registre R3 et les deuxièmes facteurs $\{b_2, b_3\}$ contenus dans le troisième registre R6 sont accumulés dans le registre de sortie R0 de la première voie VC1.

En détails, la multiplication-accumulation dans la partie droite du registre de sortie R0d de la première voie VC1 s'exprime « R0d+=R3d*R6d », et la multiplication-accumulation dans la partie gauche du registre de sortie R0g s'exprime « R0g+=R3g*R6g ».

Dans la deuxième voie VC2, l'opération de multiplication-accumulation est mise en œuvre de sorte que les deux produits $\{b_k x_{m-k}\}_{[k;k+1]}^{m=n}$ entre les premiers facteurs $\{x_{n-3}, x_{n-4}\}$ contenus dans le premier registre R3 et les deuxièmes facteurs $\{b_3, b_4\}$ contenus dans le deuxième registre R7 et dans le troisième registre R6 sont accumulés dans le registre de sortie R4 de la deuxième voie VC2.

En détails, la multiplication-accumulation dans la partie droite du registre de sortie R4d de la deuxième voie VC2 s'exprime « R4d+=R3d*R6g », et la multiplication-accumulation dans la partie gauche du registre de sortie R4g s'exprime « R4g+=R3g*R7d ».

Là encore, le circuit de sélection SWT est configuré pour faire la distribution de sorte que la partie gauche MACg de la première voie VC1 reçoit en entrée la partie gauche du premier registre R3g et la partie gauche du troisième registre R6g ; la partie droite MACd de la première voie VC1 reçoit en entrée la partie droite du premier registre R3d et la partie droite du troisième registre R6d. Tandis que la partie gauche MACg de la deuxième voie VC2 reçoit en entrée la partie gauche du premier registre R3g et la partie droite du deuxième registre R7d ; et la partie droite MACd de la deuxième voie VC2 reçoit en entrée la partie droite du premier registre R3d et la partie gauche du troisième registre R6g.

Et là encore, simultanément aux calculs de multiplication-accumulation parallèles dans les deux voies de calculs VC1, VC2, le calculateur matériel CAL est configuré pour effectuer, dans le premier registre R3, un chargement $LD(x_{n=n-2})$ de la paire de premiers facteurs $\{x_{n-5}, x_{n-6}\}$ correspondant au calcul de la prochaine opération (i.e. l'opération après la deuxième opération OP2) de la première voie VC1 et de la deuxième voie VC2 ; ainsi que, dans le troisième registre R6, un seul autre chargement $LD(b_{k=k+4})$ de la paire de deuxièmes facteurs $\{b_6, b_7\}$ correspondant au calcul de l'opération suivant la prochaine opération (i.e. suivant l'opération après la deuxième opération OP2) de la première voie VC1.

En conséquence, lors de la prochaine opération (après la deuxième opération OP2), le deuxième registre R7 et le troisième registre R6 contiendront des deuxièmes facteurs $\{b_4, b_5\}$ $\{b_6, b_7\}$ d'une manière comparable à leur contenu au commencement de la première opération OP1 et au commencement de la deuxième opération OP2.

La mise en œuvre de l'opération suivant la deuxième opération OP2 est strictement identique à la première opération OP1, du point de vue des accès et des chargements dans les registres d'entrées R3, R6, R7, mais cette fois chargés avec les données correspondant à l'avancement respectif de l'indice $k$ dans la somme $\sum_{k=0}^{N-1} b_k x_{m-k}$ du rang $m = n$ - 1.

On remarquera que, entre la première opération OP1 et la deuxième opération OP2, la différence entre toutes les actions effectuées dans le deuxième registre R7 et le troisième registre R6 correspond à une permutation, c'est-à-dire un échange strict, entre les actions faites dans le deuxième registre R7 et les actions faites dans le troisième registre R6.

En conséquence, dans la série d'opérations, le calculateur matériel CAL est configuré pour permuter les fonctions du deuxième registre R7/R6 et du troisième registre R6/R7, à chaque opération successive, l'une après l'autre. En d'autres termes, à chaque nouvelle opération, le troisième registre devient le deuxième registre et le deuxième registre devient le troisième registre, et les mêmes actions sont faites dans le « nouveau » deuxième registre et dans le « nouveau » troisième registre.

D'un autre point de vue, on peut considérer que le calculateur matériel CAL effectue toujours strictement les mêmes actions dans « un » deuxième registre et dans « un » troisième registre à chaque opération. En effet, dans la première opération OP1 (et les opération « impaires »), le deuxième registre est le registre ayant la référence R7 et le troisième registre est le registre ayant la référence R6 ; tandis que dans la deuxième opération OP2 (et les opération « paires »), les exactement mêmes actions sont exécutées dans un deuxième registre et dans un troisième registre, le deuxième registre étant le registre ayant la référence R6 et le troisième registre étant le registre ayant la référence R7.

En résumé, il a été décrit une technique de calcul matériel d'opérations de multiplication-accumulation, dans laquelle, à chaque opération composant au fur et à mesure la première composante de sortie de rang inférieur $n$ - 1, les premiers facteurs d'entrée $\{x_i, x_{i-1}\}$ sont chargés dans un premier registre R3 et les deuxièmes facteurs $\{b_j, b_{j+1}\}$ sont chargés dans un deuxième registre R7/R6. Un troisième registre R6/R7 est en outre prévu pour contenir les prochains deuxièmes facteurs $\{b_{j+2}, b_{j+3}\}$ pour la prochaine opération de la première composante de sortie de rang inférieur $n$ - 1. Parallèlement, les opérations de multiplication-accumulation pour la deuxième composante de sortie de rang consécutif supérieur $n$, entre les mêmes premiers facteurs $\{x_i, x_{i-1}\}$ chargés dans le premier registre R3, et les deuxièmes facteurs $\{b_{j+1}, b_{j+2}\}$ correspondant à ces premiers facteurs, distribués dans le deuxième registre R7/R6 et dans le troisième registre R6/R7.

En conséquence, la technique de calcul matériel ainsi résumée permet de réaliser les quatre multiplications-accumulations à chaque opération dans l'ensemble des deux voies VC1, VC2, avec seulement deux chargements dans les registres d'entrée R3, R7/R6 (REGin - figure 1).

On notera qu'une phase d'initialisation de la série, avant la toute première opération de la série, comprend trois chargements des registres d'entrée R3, R7, R6 avec les données correspondantes, par exemple telles que représentées sur la figure 2. Ensuite, dans toute la mise en œuvre de la série d'opérations, chaque opération ne comporte que deux chargements.

D'autre part, dans les expressions développées des équations $Y_{n-1}$, $Y_n$ de la formule $Y_m = \sum_{k=0}^{N-1} b_k x_{m-k}$ illustrées par les figures 2, 4 et 6, les indices $k$ des coefficients $b_k$ vont tous de 0 à N-1, tandis que les indices $m$ - $k$ des données d'entrée $x_{m-k}$ sont notés de sorte à aller du rang m correspondant au rang $m$ - ($N$ - 1). Cela étant, on entend que les valeurs d'indice, telles qu'éventuellement la valeur notée $m$ - ($N$ - 1), sont considérées modulo ($N$ - 1) de sorte que lorsque $m$ - $k < 0$ les indices effectifs valent ($N$ - 1) + ($m$ - $k$), étant donné que le vecteur d'entrée $\{x_i\}_i$ n'a typiquement pas d'indice $i$ de signe négatif. A cet égard, les valeurs des données d'entrée $\{x_i\}_i$ peuvent typiquement être stockées dans un registre circulaire, mettant en œuvre par construction la fonction de modulo.

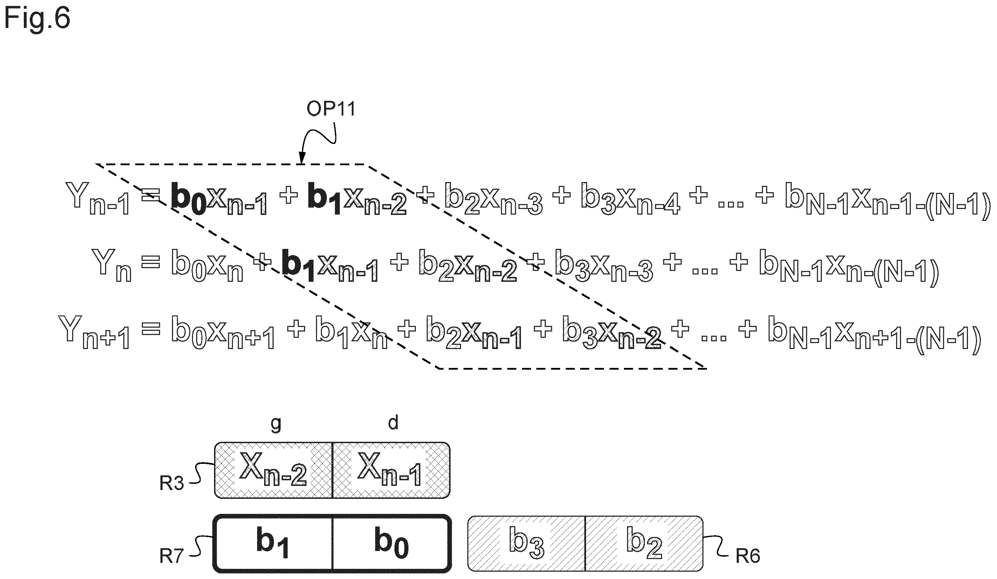

La figure 6 illustre un exemple complémentaire correspondant à un cas où le calculateur matériel comporte en outre une troisième voie de calcul (non-représentée), analogue à la première voie de calcul VC1 et à la deuxième voie de calcul VC2, adaptée pour calculer parallèlement une troisième composante de sortie $Y_{n+1}$, d'un troisième rang $n$ + 1 supérieur et consécutif au deuxième rang n, et suivant la même formule $Y_m = \sum_{k=0}^{N-1} b_k x_{m-k}$.

A chaque opération, le calculateur matériel est configuré pour calculer et accumuler dans un troisième registre de sortie (non-représenté) une paire de deux produits $\{b_k x_{m-k}\}_{[k;k+1]}^{m=n+1}$ entre les mêmes premiers facteurs $\{x_{n-1}, x_{n-2}\}$ contenus dans le premier registre R3 et les deuxièmes facteurs $\{b_{j+2}, b_{j+3}\}$ contenus dans le troisième registre R6.

Dans une première opération OP11, les opérations de multiplication-accumulation effectuées pour la première composante de sortie $Y_{n-1}$ par la première voie VC1, et pour la deuxième composante de sortie $Y_n$ par la deuxième voie VC2, correspondent précisément à la première opération OP1 décrite précédemment en relation avec les figures 2 et 3.

Ainsi, dans la première opération OP1 décrite précédemment en relation avec les figures 2 et 3, le troisième registre R6 contient les coefficients $\{b_2, b_3\}$.

Or, pour les termes de la troisième composante de sortie $Y_{n+1}$ par la troisième voie, les deuxièmes facteurs d'indices $k, k+1$ correspondant aux produits $\{b_k x_{m-k}\}_k^{m=n+1}$ avec données d'entrée $x_{n-1}$, $x_{n-2}$ pour le rang $n+1$ (i.e. $(n+1)-k = n-1$; $(n+1)-(k+1) = n-2$ soit $k = 2$; $k+1 = 3$), sont les coefficients $\{b_2, b_3\}$ contenus dans le troisième registre R6.

Les mêmes chargements que ceux décrits en relation avec les figures 2 et 3 sont faits dans les registres R3 et R7 lors de la première opération OP11.

Ensuite, dans une deuxième opération suivant la première opération OP11, le premier registre R3 contient les premiers facteurs $\{x_{n-3}, x_{n-4}\}$, le deuxième registre R7 contient les deuxièmes facteurs $\{b_4, b_5\}$ et le troisième registre R6 contient les deuxièmes facteurs $\{b_2, b_3\}$.

Ainsi, là encore les opérations de multiplication-accumulation effectuées pour la première composante de sortie $Y_{n-1}$ par la première voie VC1, et pour la deuxième composante de sortie $Y_n$ par la deuxième voie VC2, correspondent précisément à la deuxième opération OP2 décrite précédemment en relation avec les figures 4 et 5.

Et, pour les termes de la troisième composante de sortie $Y_{n+1}$ par la troisième voie, les deuxièmes facteurs d'indices $k, k+1$ correspondant aux produits $\{b_k x_{m-k}\}_k^{m=n+1}$ avec données d'entrée $x_{n-3}$, $x_{n-4}$ pour le rang $n+1$ (i.e. $(n+1)-k = n-3$; $(n+1)-(k+1) = n-4$ soit $k = 4$; $k+1 = 5$), sont les coefficients $\{b_4, b_5\}$ contenus dans le deuxième registre R7.

En conséquence, au moyen d'une troisième voie calcul supplémentaire, le calculateur matériel est capable de calculer six termes de multiplication-accumulation pour deux chargements de facteurs dans lesdits registres, à chaque opération.

La figure 7 illustre un exemple de réalisation du calculateur matériel CAL décrit précédemment en relation avec les figures 2 à 6. Le calculateur matériel CAL appartient par exemple à un processeur de signaux numériques DSP, réalisé de façon intégré au sein d'un circuit intégré, tel qu'un microcontrôleur MCU.

## Revendications

1. Circuit intégré comprenant un calculateur matériel adapté pour calculer parallèlement une première composante de sortie $Y_{n-1}$ d'un premier rang $n-1$ et une deuxième composante de sortie $Y_n$ d'un deuxième rang n supérieur et consécutif au premier rang, suivant la formule : $Y_m = \sum_{k=0}^{N-1} b_k x_{m-k}$, en une série d'opérations,

   le calculateur matériel comportant une première voie de calcul (VC1) dédiée à la première composante de sortie $Y_{n-1}$, une deuxième voie de calcul (VC2) dédiée à la deuxième composante de sortie $Y_n$, dans lequel, à chaque opération, un premier registre (R3) est configuré pour contenir une paire de premiers facteurs $\{x_i, x_{i-1}\}$ correspondant aux termes $\{b_k x_{m-k}\}_{[k;k+1]}^{m=n-1}$ de ladite opération dans la première voie (VC1), un deuxième registre (R7, R6) est configuré pour contenir une paire de deuxièmes facteurs $\{b_j, b_{j+1}\}$ correspondant aux termes $\{b_k x_{m-k}\}_{[k;k+1]}^{m=n-1}$ de ladite opération dans la première voie (VC1), et un troisième registre (R6, R7) est configuré pour contenir une paire de deuxièmes facteurs $\{b_{j+2}, b_{j+3}\}$ correspondant aux termes $\{b_k x_{m-k}\}_{[k+2;k+3]}^{m=n-1}$ de la prochaine opération dans la première voie (VC1),
   les deux voies de calculs (VC1, VC2) étant configurées pour accéder chacune au premier registre (R3), au deuxième registre (R7) et au troisième registre (R6), de manière à utiliser dans chaque opération les premiers facteurs $x_{m-k}$ et les deuxièmes facteurs $b_k$ à la position correspondante de l'indice de sommation $0 \leq k \leq N-1$ dans ladite formule de rang $m = n-1$, $m = n$ respectif à chacune des composantes de sortie $Y_{n-1}, Y_n$.

2. Circuit intégré selon la revendication 1, dans lequel, à chaque opération :

   - la première voie de calcul (VC1) est configurée pour calculer et accumuler dans un premier registre de sortie (R0) la paire de deux produits $\{b_k x_{m-k}\}_{[k;k+1]}^{m=n-1}$ entre les premiers facteurs $\{x_i, x_{i-1}\}$ contenus dans le premier registre (R3) et les deuxièmes facteurs $\{b_j, b_{j+1}\}$ contenus dans le deuxième registre (R7, R6),
   - la deuxième voie de calcul (VC2) est configurée pour calculer et accumuler dans un deuxième registre de sortie (R4) la paire de deux produits $\{b_k x_{m-k}\}_{[k;k+1]}^{m=n}$ entre les mêmes

premiers facteurs $\{x_i, x_{i-1}\}$ contenus dans le premier registre (R3) et les deuxièmes facteurs $\{b_{j+1}, b_{j+2}\}$ correspondant au calcul du deuxième rang $n$, contenus dans le deuxième registre (R7g, R6d) et dans le troisième registre (R6g, R7d) ;

- le calculateur matériel est configuré pour charger dans le premier registre (R3) une paire de premiers facteurs $\{x_{i-2}, x_{i-3}\}$ correspondant au calcul de la prochaine opération de la première voie (VC1), et pour charger dans le deuxième registre une paire de deuxièmes facteurs $\{b_{j+4}, b_{j+5}\}$ correspondant au calcul de l'opération suivant la prochaine opération de la première voie (VC1).

3. Circuit intégré selon l'une des revendications précédentes, dans lequel le calculateur matériel est configuré, dans la série d'opérations, pour permuter les fonctions du deuxième registre (R7, R6) et du troisième registre (R6, R7), à chaque opération successive.

4. Circuit intégré selon l'une des revendications précédentes, dans lequel le premier registre (R3), le deuxième registre (R7, R6), le troisième registre (R6, R7) ainsi que le premier registre de sortie (R0) et le deuxième registre de sortie (R4) ont une taille de 2M bits et contiennent chacun une paire de deux données codées sur M bits.

5. Circuit intégré selon l'une des revendications précédentes, dans lequel le calculateur matériel comporte un circuit de sélection (SWT) configuré pour distribuer les accès au deuxième registre (R7, R6) et au troisième registre (R6, R7) à la première voie de calcul (VC1) et à la deuxième voie de calcul (VC2), de sorte que la première voie (VC1) ait accès aux deuxièmes facteurs $\{b_j, b_{j+1}\}$ correspondant à ladite opération contenus dans le deuxième registre (R7, R6), et que la deuxième voie (VC2) ait accès aux deuxièmes facteurs $\{b_{j+2}, b_{j+3}\}$ correspondant à ladite opération contenus dans le deuxième registre (R7, R6) et dans le troisième registre (R6, R7).

6. Circuit intégré selon l'une des revendications précédentes, dans lequel le calculateur matériel est adapté en outre pour calculer parallèlement une troisième composante de sortie $Y_{n+1}$, d'un troisième rang $n + 1$ supérieur et consécutif au deuxième rang $n$, suivant la même formule, le calculateur matériel comportant une troisième voie de calcul dédiée à la troisième composante de sortie $Y_{n+1}$, et dans lequel, à chaque opération, le calculateur matériel est en outre configuré pour :

- avec la troisième voie, calculer et accumuler dans un troisième registre de sortie une paire de deux produits $\{b_k x_{m-k}\}_{[k;k+1]}^{m=n+1}$ entre les mêmes premiers facteurs $\{x_i, x_{i-1}\}$ contenus dans le premier registre (R3) et les deuxièmes facteurs $\{b_{j+2}, b_{j+3}\}$ correspondant au calcul du troisième rang $n + 1$, contenus dans le troisième registre (R6, R7).

7. Circuit intégré selon l'une des revendications précédentes, incorporant un processeur de signaux numériques (DSP).

8. Procédé, mis en œuvre au sein d'un calculateur matériel, de calcul parallèle d'une première composante de sortie $Y_{n-1}$ d'un premier rang $n - 1$ et d'une deuxième composante de sortie $Y_n$ d'un deuxième rang $n$ supérieur et consécutif au premier rang, suivant la formule : $Y_m = \sum_{k=0}^{N-1} b_k x_{m-k}$ , en une série d'opérations, dans lequel, à chaque opération :

- le calcul de la première composante $Y_{n-1}$ comprend un calcul et une accumulation de deux produits $\{b_k x_{m-k}\}_{[k;k+1]}^{m=n-1}$ entre des premiers facteurs $\{x_i, x_{i-1}\}$ contenus dans un premier registre (R3) et des deuxièmes facteurs $\{b_j, b_{j+1}\}$ contenus dans un deuxième registre (R7, R6) ;
- le calcul de la deuxième composante $Y_n$ comprend un calcul et une accumulation de deux produits $\{b_k x_{m-k}\}_{[k;k+1]}^{m=n}$ entre les mêmes premiers facteurs $\{x_i, x_{i-1}\}$ contenus dans le premier registre (R3) et des deuxièmes facteurs $\{b_{j+1}, b_{j+2}\}$ correspondant au calcul du deuxième rang n, contenus dans le deuxième registre (R7, R6) et dans un troisième registre (R6, R7) ;
- un chargement, dans le premier registre (R3), d'une paire de premiers facteurs $\{x_{i-2}, x_{i-3}\}$ correspondant au calcul de la prochaine opération,
- un chargement, dans le deuxième registre (R7, R6), d'une paire de deuxièmes facteurs $\{b_{j+4}, b_{j+5}\}$ correspondant au calcul de l'opération suivant la prochaine opération de la première voie (VC1).

9. Procédé selon la revendication 8, comprenant, dans la série d'opérations, une permutation des fonctions du deuxième registre (R7, R6) et du troisième registre (R6, R7), à chaque opération successive.

10. Procédé selon l'une des revendications 8 ou 9 dans lequel le premier registre (R3), le deuxième registre (R7, R6), le troisième registre (R6, R7) ainsi que le premier registre de sortie (R0) et le deuxième registre de sortie (R4) ont une taille de 2M bits et contiennent chacun une paire de deux données codées sur M bits.

11. Procédé selon l'une des revendications 8 à 10, dans lequel les accès au deuxième registre (R7, R6) et au troisième registre (R6, R7) sont distribués de sorte qu'une première voie de calcul (VC1) dédiée à la première composante de sortie $Y_{n-1}$, ait accès aux deuxièmes facteurs $\{b_j, b_{j+1}\}$ correspondant à ladite opération contenus dans le deuxième registre (R7, R6), et qu'une deuxième voie de calcul (VC2) dédiée à la deuxième composante de sortie $Y_n$, ait accès aux deuxièmes facteurs $\{b_{j+2}, b_{j+3}\}$ correspondant à ladite opération contenus dans le deuxième registre (R7, R6) et dans le troisième registre (R6, R7).

12. Procédé selon l'une des revendications 8 à 11, comprenant en outre un calcul parallèle d'une troisième composante de sortie $Y_{n+1}$, d'un troisième rang $n + 1$ supérieur et consécutif au deuxième rang $n$, suivant la même formule, dans lequel, à chaque opération, le procédé comprend en outre :

- le calcul de la troisième composante $Y_{n+1}$ comprend un calcul et une accumulation de deux produits $\{b_k x_{m-k}\}_{[k;k+1]}^{m=n+1}$ entre les mêmes premiers facteurs $\{x_i, x_{i-1}\}$ contenus dans le premier registre (R3) et les deuxièmes facteurs $\{b_{j+2}, b_{j+3}\}$ correspondant au calcul du troisième rang $n + 1$, contenus dans le troisième registre (R6, R7).

**Patentansprüche**

1. Integrierte Schaltung, die einen Hardwarerechner umfasst, der dazu ausgelegt ist, parallel eine erste Ausgangskomponente $Y_{n-1}$ eines ersten Ranges n - 1 und eine zweite Ausgangskomponente $Y_n$ eines zweiten höheren und auf den ersten Rang folgenden Ranges $n$ nach folgender Formel:

$$Y_m = \sum_{k=0}^{N-1} b_k x_{m-k}$$, in einer Reihe von Vorgängen zu berechnen,

wobei der Hardwarerechner einen ersten Berechnungsweg (VC1), der der ersten Ausgangskomponente $Y_{n-1}$ gewidmet ist, einen zweiten Berechnungsweg (VC2), der der zweiten Ausgangskomponente $Y_n$ gewidmet ist, aufweist, in dem, bei jedem Vorgang, ein erstes Register (R3) so eingerichtet ist, dass es ein Paar erster Faktoren $\{x_i, x_{i-1}\}$ enthält, die den Begriffen

$\{b_k x_{m-k}\}_{[k;k+1]}^{m=n-1}$ des Vorgangs in dem ersten Weg (VC1) entsprechen, ein zweites Register (R7, R6) so eingerichtet ist, dass es ein Paar zweiter Faktoren $\{b_j, b_{j+1}\}$ enthält, die den Begriffen $\{b_k x_{m-k}\}_{[k;k+1]}^{m=n-1}$ des Vorgangs in dem ersten Weg (VC1) entsprechen, und ein drittes Register (R6, R7) so eingerichtet ist, dass es ein Paar zweiter Faktoren $\{b_{j+2}, b_{j+3}\}$ enthält, die den Begriffen $\{b_k x_{m-k}\}_{[k+2;k+3]}^{m=n-1}$ des nächsten Vorgangs in dem ersten Weg (VC1) entsprechen,
wobei die beiden Berechnungswege (VC1, VC2) so eingerichtet sind, dass sie jeweils auf das erste Register (R3), das zweite Register (R7) und das dritte Register (R6) zugreifen, so dass in jedem Vorgang die ersten Faktoren $x_{m-k}$ und die zweiten Faktoren $b_k$ an der entsprechenden Position des Summationsindex $0 \le k \le N - 1$ in der Rangformel $m = n - 1$, $m = n$ für jede der Ausgangskomponenten $Y_{n-1}$, $Y_n$ verwendet werden.

2. Integrierte Schaltung nach Anspruch 1, wobei bei jedem Vorgang:

- der erste Berechnungsweg (VC1) so eingerichtet ist, dass er in einem ersten Ausgangsregister (R0) das Paar von zwei Produkten $\{b_k x_{m-k}\}_{[k;k+1]}^{m=n-1}$ aus den ersten Faktoren $\{x_i, x_{i-1}\}$, die in dem ersten Register (R3) enthalten sind, und den zweiten Faktoren $\{b_j, b_{j+1}\}$, die in dem zweiten Register (R7, R6) enthalten sind, berechnet und akkumuliert,
- der zweite Berechnungsweg (VC2) so eingerichtet ist, dass er in einem zweiten Ausgangsregister (R4) das Paar von zwei Produkten $\{b_k x_{m-k}\}_{[k;k+1]}^{m=n}$ aus den gleichen ersten Faktoren $\{x_i, x_{i-1}\}$, die in dem ersten Register (R3) enthalten sind, und den zweiten Faktoren $\{b_{j+1}, b_{j+1}\}$, die der Berechnung des zweiten Ranges n entsprechen, die in dem zweiten Register (R7g, R6d) und in dem dritten Register (R6g, R7d) enthalten sind, berechnet und akkumuliert;
- der Hardwarerechner so eingerichtet ist, dass er in das erste Register (R3) ein Paar erster Faktoren $\{x_{i-2}, x_{i-3}\}$ lädt, das der Berechnung des nächsten Vorgangs des ersten Wegs (VC1) entspricht, und dass er in das zweite Register ein Paar zweiter Faktoren $\{b_{j+4}, b_{j+5}\}$ lädt, das der Berechnung des Vorgangs nach dem nächsten Vorgang des ersten Wegs (VC1) entspricht.

3. Integrierte Schaltung nach einem der vorhergehenden Ansprüche, wobei der Hardwarerechner in der Reihe von Vorgängen so eingerichtet ist, dass er bei jedem aufeinanderfolgenden Vorgang die Funktionen des zweiten Registers (R7, R6) und des dritten Registers (R6, R7) umschaltet.

4. Integrierte Schaltung nach einem der vorhergehenden Ansprüche, wobei das erste Register (R3), das zweite Register (R7, R6), das dritte Register (R6, R7) sowie das erste Ausgangsregister (R0) und das zweite Ausgangsregister (R4) eine Größe von 2M Bits aufweisen und jeweils ein Paar von zwei auf M Bits codierten Daten enthalten.

5. Integrierte Schaltung nach einem der vorhergehenden Ansprüche, wobei der Hardwarerechner einen Auswahlschaltkreis (SWT) umfasst, der so eingerichtet ist, dass er die Zugriffe auf das zweite Register (R7, R6) und das dritte Register (R6, R7) auf den ersten Berechnungsweg (VC1) und den zweiten Berechnungsweg (VC2) verteilt, so dass der erste Weg (VC1) Zugriff auf die zweiten Faktoren $\{b_j, b_{j+1}\}$ hat, die dem in dem zweiten Register (R7, R6) enthaltenen Vorgang entsprechen, und dass der zweite Weg (VC2) Zugang zu den zweiten Faktoren $\{b_{j+2}, b_{j+3}\}$ hat, die dem besagten Vorgang in dem zweiten Register (R7, R6) und in dem dritten Register (R6, R7) entsprechen.

6. Integrierte Schaltung nach einem der vorhergehenden Ansprüche, wobei der Hardwarerechner ferner dazu ausgelegt ist, parallel eine dritte Ausgangskomponente $Y_{n+1}$, eines dritten höheren Ranges $n + 1$ und nach dem zweiten Rang n, nach derselben Formel zu berechnen, wobei der Hardwarerechner einen dritten Berechnungsweg aufweist, der der dritten Ausgangskomponente $Y_{n+1}$ gewidmet ist, und wobei der Hardwarerechner bei jedem Vorgang ferner eingerichtet ist, um:

- mit dem dritten Weg ein Paar von zwei Produkten $\{b_k x_{m-k}\}_{[k;k+1]}^{m=n+1}$ aus den gleichen ersten Faktoren $\{x_i, x_{i-1}\}$, die in dem ersten Register (R3) enthalten sind, und den zweiten Faktoren $\{b_{j+2}, b_{j+3}\}$, die der Berechnung des dritten Ranges $n + 1$ entsprechen und in dem dritten Register (R6, R7) enthalten sind, zu berechnen und in einem dritten Ausgangsregister zu akkumulieren.

7. Integrierte Schaltung nach einem der vorhergehenden Ansprüche, die einen digitalen Signalprozessor (DSP) beinhaltet.

8. Verfahren zur parallelen Berechnung einer ersten Ausgangskomponente $Y_{n-1}$ eines ersten Ranges n - 1 und einer zweiten Ausgangskomponente $Y_n$ eines zweiten höheren und auf den ersten Rang folgenden Ranges n innerhalb eines Hardwarerechners nach der Formel: $Y_m = \sum_{k=0}^{N-1} b_k x_{m-k}$ , in einer Reihe von Vorgängen, wobei bei jedem Vorgang:

- die Berechnung der ersten Komponente $Y_{n-1}$ eine Berechnung und eine Akkumulation von zwei Produkten $\{b_k x_{m-k}\}_{[k;k+1]}^{m=n-1}$ aus ersten Faktoren $\{x_i, x_{i-1}\}$, die in einem ersten Register (R3) enthalten sind, und zweiten Faktoren $\{b_j, b_{j+1}\}$, die in einem zweiten Register (R7, R6) enthalten sind, umfasst;
- die Berechnung der zweiten Komponente $Y_n$ eine Berechnung und eine Akkumulation von zwei Produkten $\{b_k x_{m-k}\}_{[k;k+1]}^{m=n}$ aus denselben ersten Faktoren $\{x_i, x_{i-1}\}$, die in dem ersten Register (R3) enthalten sind, und den zweiten Faktoren $\{b_{j+1}, b_{j+1}\}$, die der Berechnung des zweiten Ranges n entsprechen, die in dem zweiten Register (R7, R6) und in einem dritten Register (R6, R7) enthalten sind, umfasst;
- ein Laden eines Paares von ersten Faktoren $\{x_{i-2}, x_{i-3}\}$ in dem ersten Register (R3), das der Berechnung des nächsten Vorgangs entspricht,
- ein Laden eines Paares von zweiten Faktoren $\{b_{j+4}, b_{j+5}\}$ in dem zweiten Register (R7, R6), das der Berechnung des Vorgangs nach dem nächsten Vorgang des ersten Wegs (VC1) entspricht.

9. Verfahren nach Anspruch 8, umfassend, in der Reihe von Vorgängen, ein Wechseln der Funktionen des zweiten Registers (R7, R6) und des dritten Registers (R6, R7) bei jedem aufeinanderfolgenden Vorgang.

10. Verfahren nach einem der Ansprüche 8 oder 9, wobei das erste Register (R3), das zweite Register (R7, R6), das dritte Register (R6, R7) sowie das erste Ausgangsregister (R0) und das zweite Ausgangsregister (R4) eine Größe von 2M Bits aufweisen und jeweils ein Paar von zwei auf M Bits codierten Daten enthalten.

11. Verfahren nach einem der Ansprüche 8 bis 10, wobei die Zugänge zu dem zweiten Register (R7, R6) und zu dem dritten Register (R6, R7) so verteilt sind, dass ein erster Berechnungsweg (VC1), der für die erste Ausgangskomponente $Y_{n-1}$ bestimmt ist, Zugang zu den zweiten Faktoren $\{b_j, b_{j+1}\}$ hat, die dem Vorgang entsprechen, der in dem zweiten Register (R7, R6) enthalten ist, und ein zweiter Berechnungsweg (VC2), der für die zweite Ausgangskomponente $Y_n$ bestimmt ist, Zugang zu den zweiten Faktoren $\{b_{j+2}, bj_{+3}\}$ hat, die dem Vorgang in dem zweiten Register (R7, R6) und in dem dritten Register (R6, R7) entsprechen.

12. Verfahren nach einem der Ansprüche 8 bis 11, ferner umfassend eine parallele Berechnung einer dritten Ausgangskomponente $Y_{n+1}$, eines dritten höheren Ranges n + 1 und nach dem zweiten Rang n nach derselben Formel, wobei das Verfahren bei jedem Vorgang ferner Folgendes umfasst:

- die Berechnung der dritten Komponente $Y_{n+1}$ umfasst eine Berechnung und eine Akkumulation von zwei Produkten $\left\{b_k x_{m-k}\right\}_{[k;k+1]}^{m=n+1}$ aus denselben ersten Faktoren $\{x_i, x_{i-1}\}$, die in dem ersten Register (R3) enthalten sind, und den zweiten Faktoren $\{b_{j+2}, b_{j+3}\}$, die der Berechnung des dritten Ranges $n$ + 1 entsprechen und in dem dritten Register (R6, R7) enthalten sind.

**Claims**

1. An integrated circuit comprising a hardware computer to compute in parallel a first output component $Y_{n-1}$ of a first rank $n$ - 1 and a second output component $Y_n$ of a second rank $n$ greater than and consecutive to the first rank, according to the formula:

$$Y_m = \sum_{k=0}^{N-1} b_k x_{m-k}$$ , in a series of operations, the hardware computer comprising a first computing path (VC1) assigned to the first output component $Y_{n-1}$, a second computing path (VC2) assigned to the second output component $Y_n$, wherein, for each operation, a first registry (R3) is configured to contain a pair of first factors $\{x_i, x_{i-1}\}$ corresponding to the terms $\left\{b_k x_{m-k}\right\}_{[k;k+1]}^{m=n-1}$ of said operation in the first path (VC1), a second registry (R7, R6) is configured to contain a pair of second factors $\{bj, b_{j+1}\}$ corresponding to the terms $\left\{b_k x_{m-k}\right\}_{[k;k+1]}^{m=n-1}$ of said operation in the first path (VC1), and a third registry (R6, R7) is configured to contain a pair of second factors $\{b_{j+2}, b_{j+3}\}$ corresponding to the terms $\left\{b_k x_{m-k}\right\}_{[k+2;k+3]}^{m=n-1}$ of the next operation in the first path (VC1), the two computing paths (VC1, VC2) being configured to each access the first registry (R3), the second registry (R7), and the third registry (R6) respectively, so as to use the first factors $x_{m-k}$ and the second factors $b_k$ at the corresponding position of the summation index $0 \le k \le N$ - 1 in said formula of rank $m = n$ - 1, $m = n$ with respect to each of the output components $Y_{n-1}$, $Y_n$.

2. The integrated circuit according to claim 1, wherein, for each operation:

- the first computing path (VC1) is configured to compute and accumulate in a first output registry (R0) the pair of two products $\left\{b_k x_{m-k}\right\}_{[k;k+1]}^{m=n-1}$ between the first factors $\{x_i, x_{i-1}\}$ contained in the first registry (R3) and the second factors $\{b_j, b_{j+1}\}$ contained in the second registry (R7, R6),
- the second computing path (VC2) is configured to compute and accumulate in a second output registry (R4) the pair of two products $\left\{b_k x_{m-k}\right\}_{[k;k+1]}^{m=n}$ between the same first factors $\{x_i, x_{i-1}\}$ contained in the first registry (R3) and the second factors $\{b_{j+1}, b_{j+2}\}$ corresponding to the computing of the second rank n, contained in the second registry (R7g, R6d) and in the third registry (R6g, R7d);
- the hardware computer is configured to load in the first registry (R3) a pair of first factors $\{x_{i-2}, x_{i-3}\}$ corresponding to the computing of the next operation of the first path (VC1), and to load in the second registry a pair of second factors $\{b_{j+4}, b_{j+5}\}$ corresponding to the computing of the operation following the next operation of the first path (VC1).

3. The integrated circuit according to one of the preceding claims, wherein the hardware computer is configured, in the series of operations, to permute the functions of the second registry (R7, R6) and the third registry (R6, R7), for each successive operation.

4. The integrated circuit according to one of the preceding claims, wherein the first registry (R3), the second registry (R7, R6), the third registry (R6, R7) as well as the first output registry (R0) and the second output registry (R4) have a size of 2M bits and each contain a pair of two data items encoded on M bits.

5. The integrated circuit according to one of the preceding claims, wherein the hardware computer comprises a selection circuit (SWT) configured to distribute accesses to the second registry (R7, R6) and to the third registry (R6, R7) to the first computing path (VC1) and to the second computing path (VC2), such that the first path (VC1) has access to the second factors $\{b_j, b_{j+1}\}$ corresponding to said operation contained in the second registry (R7, R6), and the second path (VC2) has access to the second factors $\{b_{j+2}, b_{j+3}\}$ corresponding to said operation contained in the second registry (R7, R6) and in the third registry (R6, R7).

6. The integrated circuit according to one of the preceding claims, wherein the hardware computer is furthermore adapted to compute in parallel a third output component $Y_{n+1}$, of a third rank n + 1 greater than and consecutive to the second rank n, according to the same formula, the hardware computer comprising a third computing path assigned to the third output component $Y_{n+1}$, and wherein, for each operation, the hardware computer is furthermore configured:

- with the third path, to calculate and accumulate in a third output registry a pair of two products $\left\{b_k X_{m\text{-}k}\right\}_{[k;k+1]}^{m=n+1}$ between the same first factors $\{x_i, x_{i\text{-}1}\}$ contained in the first registry (R3) and the second factors $\{b_{j+2}, b_{j+3}\}$ corresponding to the computing of the third rank $n$ + 1, contained in the third registry (R6, R7).

7. The integrated circuit according to any of the preceding claims, incorporating a digital signal processor (DSP).

8. A method, implemented within a hardware computer, of parallel computing of a first output component $Y_{n\text{-}1}$ of a first rank n - 1 and a second output component $Y_n$ of a second rank n greater than and consecutive to the first rank, according to the formula:

$$Y_m = \sum_{k=0}^{N\text{-}1} b_k X_{m\text{-}k}$$, in a series of operations, wherein, for each operation:

- computing the first component $Y_{n\text{-}1}$ comprises computing and accumulation of two products $\left\{b_k X_{m\text{-}k}\right\}_{[k;k+1]}^{m=n\text{-}1}$ between first factors $\{x_i, x_{i\text{-}1}\}$ contained in a first registry (R3) and second factors $\{bj, b_{j+1}\}$ contained in a second registry (R7, R6);
- computing the second component $Y_n$ comprises computing and accumulation of two products $\left\{b_k X_{m\text{-}k}\right\}_{[k;k+1]}^{m=n}$ between the same first factors $\{x_i, x_{i\text{-}1}\}$ contained in the first registry (R3) and the second factors $\{b_{j+1}, b_{j+2}\}$ corresponding to the computing of the second rank n, contained in the second registry (R7, R6) and in a third registry (R6, R7);
- loading, in the first registry (R3), of a pair of initial factors $\{x_{i\text{-}2}, x_{i\text{-}3}\}$ corresponding to the computing of the next operation,
- loading, in the second registry (R7, R6), of a pair of second factors $\{b_{j+4}, b_{j+5}\}$ corresponding to the computing of the operation following the next operation of the first path (VC1).

9. The method according to claim 8, comprising, in the series of operations, a permutation of the functions of the second registry (R7, R6) and the third registry (R6, R7), for each successive operation.

10. The method according to one of claims 8 or 9 wherein the first registry (R3), the second registry (R7, R6), the third registry (R6, R7) as well as the first output registry (R0) and the second output registry (R4) have a size of 2M bits and each contain a pair of two data items encoded on M bits.

11. The method according to one of claims 8 to 10, wherein accesses to the second registry (R7, R6) and to the third registry (R6, R7) are distributed such that a first computing path (VC1) assigned to the first output component $Y_{n\text{-}1}$ has access to the second factors $\{b_j, b_{j+1}\}$ corresponding to said operation contained in the second registry (R7, R6), and a second computing (VC2) assigned to the second output component $Y_n$ has access to the second factors $\{b_{j+2}, b_{j+3}\}$ corresponding to said operation contained in the second registry (R7, R6) and in the third registry (R6, R7).

12. The method according to one of claims 8 to 11, further comprising parallel computing of a third output component $Y_{n+1}$, of a third rank n + 1 greater than and consecutive to the second rank n, according to the same formula, wherein, for each operation, the method further comprises:

- computing the third component $Y_{n+1}$ comprises computing and accumulation of two products $\left\{b_k X_{m\text{-}k}\right\}_{[k;k+1]}^{m=n+1}$ between the same first factors $\{x_i, x_{i\text{-}1}\}$ contained in the first registry (R3) and the second factors $\{b_{j+2}, bj_{+3}\}$ corresponding to computing of the third rank n + 1, contained in the third registry (R6, R7).

EP 4 170 479 B1

# Fig.1

Fig.2

OP1

$$Y_{n-1} = b_0 x_{n-1} + b_1 x_{n-2} + b_2 x_{n-3} + b_3 x_{n-4} + \ldots + b_{N-1} x_{n-1-(N-1)}$$

$$Y_n = b_0 x_n + b_1 x_{n-1} + b_2 x_{n-2} + b_3 x_{n-3} + \ldots + b_{N-1} x_{n-(N-1)}$$

g          d

R3 — | $x_{n-2}$ | $x_{n-1}$ |

R7 — | $b_1$ | $b_0$ |          | $b_3$ | $b_2$ | — R6

# Fig.3

# Fig.4

$$Y_{n-1} = b_0 x_{n-1} + b_1 x_{n-2} + b_2 x_{n-3} + b_3 x_{n-4} + \mathbf{b_4} x_{n-5} + \mathbf{b_5} x_{n-6} + \dots + b_{N-1} x_{n-1-(N-1)}$$

$$Y_n = b_0 x_n + b_1 x_{n-1} + b_2 x_{n-2} + b_3 x_{n-3} + \mathbf{b_4} x_{n-4} + \mathbf{b_5} x_{n-5} + \dots + b_{N-1} x_{n-(N-1)}$$

OP2

g d

R3 — $x_{n-4}$ | $x_{n-3}$

R7 — $b_5$ | $b_4$       $b_3$ | $b_2$ — R6

EP 4 170 479 B1

Fig.5

Fig.6

$$Y_{n-1} = b_0 x_{n-1} + b_1 x_{n-2} + b_2 x_{n-3} + b_3 x_{n-4} + \ldots + b_{N-1} x_{n-1-(N-1)}$$

$$Y_n = b_0 x_n + b_1 x_{n-1} + b_2 x_{n-2} + b_3 x_{n-3} + \ldots + b_{N-1} x_{n-(N-1)}$$

$$Y_{n+1} = b_0 x_{n+1} + b_1 x_n + b_2 x_{n-1} + b_3 x_{n-2} + \ldots + b_{N-1} x_{n+1-(N-1)}$$

OP11

R3 — | $X_{n-2}$ (g) | $X_{n-1}$ (d) |

R7 — | $b_1$ | $b_0$ |

| $b_3$ | $b_2$ | — R6

EP 4 170 479 B1

Fig.7

MCU

DSP

CAL